# EUROPEAN PATENT SPECIFICATION

(11) **EP 0 624 903 B1**
(45) Date of publication and mention of the grant of the patent: **30.12.1998**
(21) Application number: 93830179.3
(22) Date of filing: 28.04.1993
(51) Int. Cl.: H01L 23/528, H01L 23/50

(54) **A modular integrated circuit structure**
Modulare integrierte Schaltungsstruktur
Structure à circuit intégré modulaire

(43) Date of publication of application: 17.11.1994
(73) Proprietor: STMicroelectronics S.r.l., 20041 Agrate Brianza (Milano) (IT)
(72) Inventor: Foletto, Gianni, I-37058 Sanguinetto-Verona (IT); Fusciello, Raffaele, I-20157 Milano (IT); Lesma, Silvia, I-20091 Bresso - Milano (IT); Taliercio, Michele, I-20010 Arluno - Milano (IT); Licciardi, Luigi, I-13100 Vercelli (IT)
(74) Representative: Maggioni, Claudio

(56) References cited:
- US-A- 4 748 494
- US-A- 4 947 229
- US-A- 4 988 636
- IEEE SOLID-STATE CIRCUITS CONFERENCE, February 1988, NEW YORK, US pages 74 - 75 'A 640k transistor sea-of-gates 1.2 micromicron hcmos technology'

## Description

This invention relates to semiconductor monolithic integrated circuits, and in particular to an integrated circuit structure for processing digital data which comprises a plurality of circuit modules, each composed of various circuit elements.

As is known, a monolithic integrated circuit is a substantially planar structure consisting of active and passive electronic components which are formed on a substrate of a semiconductor material by local modification, using known masking and doping techniques, of the conduction properties of the semiconductor and forming on the substrate electrically conductive paths for interconnecting components or functional groups and selectively controlling the conductivity of the active components during the circuit operation. The circuit architecture or design, i.e. the layout of the components and functional groups on the substrate and the pattern of interconnecting and control paths, is settled to provide a circuit having the functional features sought.

The design of very large scale integrated (VLSI) circuits, particularly of logic networks for processing digital data, is known to include standard cells, or elementary cells, each capable of performing a predetermined function. Such standard cells may either comprise comparatively simple circuits, such as logic gates and bistable circuits, or more complex circuits, such as add/subtractors, comparators, converters, etc.. To provide a predetermined logic network, a number of standard cells must be selected and suitably connected together, and a set of masks prepared to define the architecture of a circuit to be implemented on the semiconductor substrate.

Two factors that should never be overlooked in the manufacture of VLSI circuits are the size of the substrate area occupied and the length of the electric interconnections; both the area occupied and the length of the interconnections should be the smallest possible, because an optimum utilization of the available area would afford savings in production costs and shorter interconnections would bring about functional advantages, especially in terms of processing rate. Normally, successful attempts to fill the former demand also contribute toward satisfying the latter.

US-A-4 988 636 discloses a method of arranging elementary cells of input/output circuitry on a substrate.

US-A-4 947 229 discloses power source wiring consisting of sections extending in orthogonal directions and formed from two levels of metallisation.

In the instance of complex logic networks, the layout and interconnection steps are carried out with the aid of automatic computer-controlled instruments such as the so-called CAD (Computer Aided Design) systems. In this respect, a much felt need is that the geometric description of the circuit layout be made as straightforward as possible, so that it can be represented by simple programs consistent with the general CAD programs used for designing integrated circuits.

The standard cells usually available for designing and making complex modular circuits are configured to suit a range of different applications; specifically, they are designed for utmost freedom of interconnection. This is, of course, advantageous from the standpoint of their flexibility but less so from that of optimum utilization of the substrate area and simplicity of the geometric representation algorithm, and hence, of its adaptability to an available CAD environment.

It is a primary object of this invention to provide an overall circuit architecture which can be used to advantage in the manufacture of large scale integrated circuits for digital data processing.

This object is achieved by a structure as defined in the first of the appended claims to this specification.

The invention can be better understood by reference to the following detailed description of an exemplary, and hence in no way limitative, embodiment thereof, to be read in conjunction with the accompanying drawings, in which:
Figure 1 shows, in block diagram form, an example of a modular circuit for processing a data stream;
Figure 2 shows schematically a structure according to the invention for implementing the circuit of Figure 1;
Figure 3 shows the layout of electric connection paths for use with the circuit structure of Figure 2; and
Figure 4 shows the layout of part of the structure in Figure 2 as it appears at a final step of the manufacturing process.

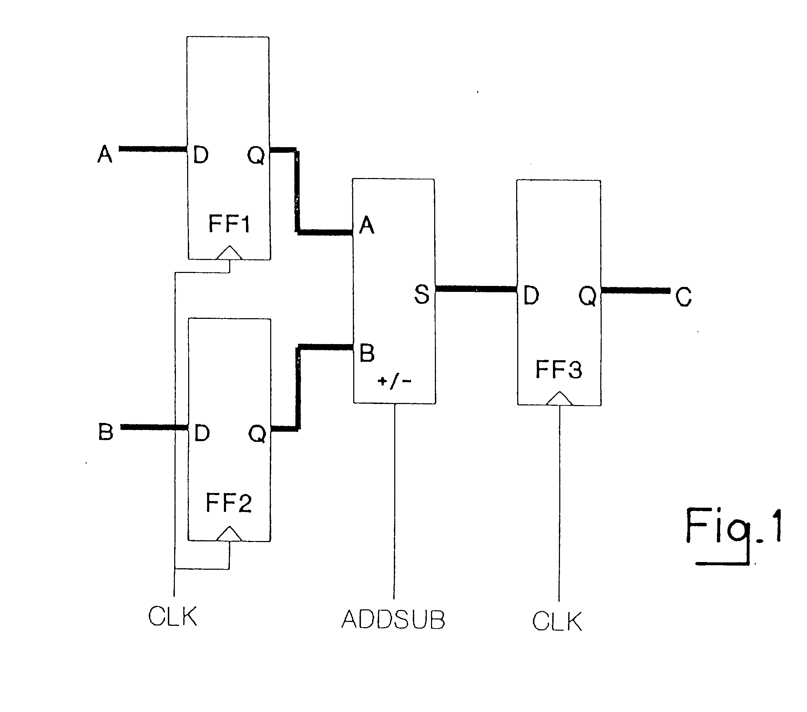

The block diagram of Figure 1 represents a circuit for adding or subtracting two digital data. It comprises two ingoing registers, such as two D-type flip-flops denoted by FF1 and FF2, an add/subtractor circuit denoted by the reference "+/-", and an outgoing register, being also a D-type flip-flop, denoted by FF3. Two data A and B to be summed are applied, through the ingoing registers FF1 and FF2, to the add/subtractor circuit +/- and the output from the latter, which is the resultant data S from the add or subtract operation, is applied to the outgoing register FF3 whence it will be output as data C. Control signals, in the form of clock signals CLK and add or subtract command signals ADDSUB, are applied to respective control inputs of the ingoing and outgoing registers and of the add/subtractor circuit for timing and executing the operation. The input data A and B consist of sets (words) of binary digits (bits) which are processed in parallel by functional elements making up the functional blocks FF1, FF2, +/- and FF3. The output data C is also a set comprising the same number of bits.

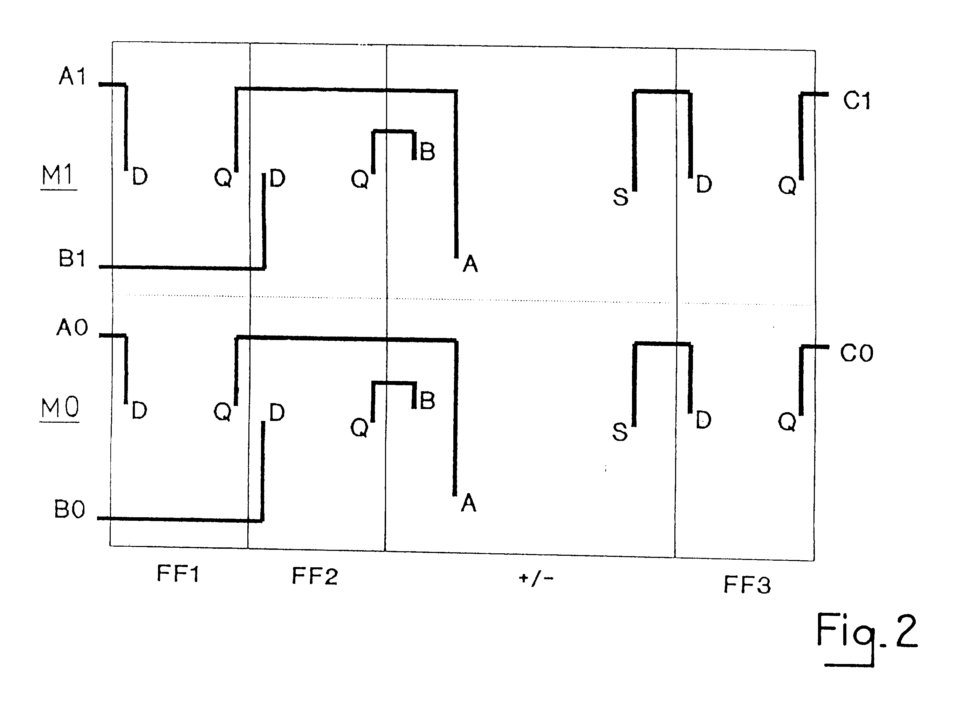

In Figure 2, where the same references as in Figure 1 are used to denote similar elements, the function depicted in Figure 1 is applied to two words A and B comprising two bits each, respectively A0, A1 and B0, B1. Understandably, this is a specially simple extreme example that has been chosen for base of illustration; the number of bits per word would normally be either 8 or 16 or 32.

According to one aspect of the invention, the functional elements which jointly make up a bit processing circuit, referred to as functional circuit module, or briefly, functional module hereinafter, are arranged adjacent to each other along a first direction, also referred to as the horizontal direction, and the several equal functional modules thus obtained are arranged adjacent to each other along a second direction, orthogonal to the first and referred to as the vertical direction. Further, the functional elements have all the same vertical spread. The several functional elements form, therefore, a compact structure wherein adjacent elements either have one side in common or are only separated by a narrow gap containing no electronic components. In this example, since the words to be processed are two-bit words, the modular circuit comprises two functional modules, denoted by M0 and M1 in the drawing, which process in parallel bits of the same order in each word. The input and output terminals of the two functional modules are aligned vertically into respective columns.

The functional elements, or elementary cells, are finite circuits integrated to substrate areas demarcated by rectangles in Figure 2 and are not further illustrated. In an actual embodiment of the invention, such circuits are CMOS (Complementary Metal Oxide Semiconductor) integrated circuits formed by a 0.7 µm technology. They are connected together by interconnection leads which extend over the integrated structures of the elementary cells to implement the circuit diagram of Figure 1. The control signal inputs have been omitted from Figure 2 for simplicity; actually, conductors would be arranged to convey such signals to respective functional elements. Also provided are supply conductors, not shown in Figure 2, to the individual cells.

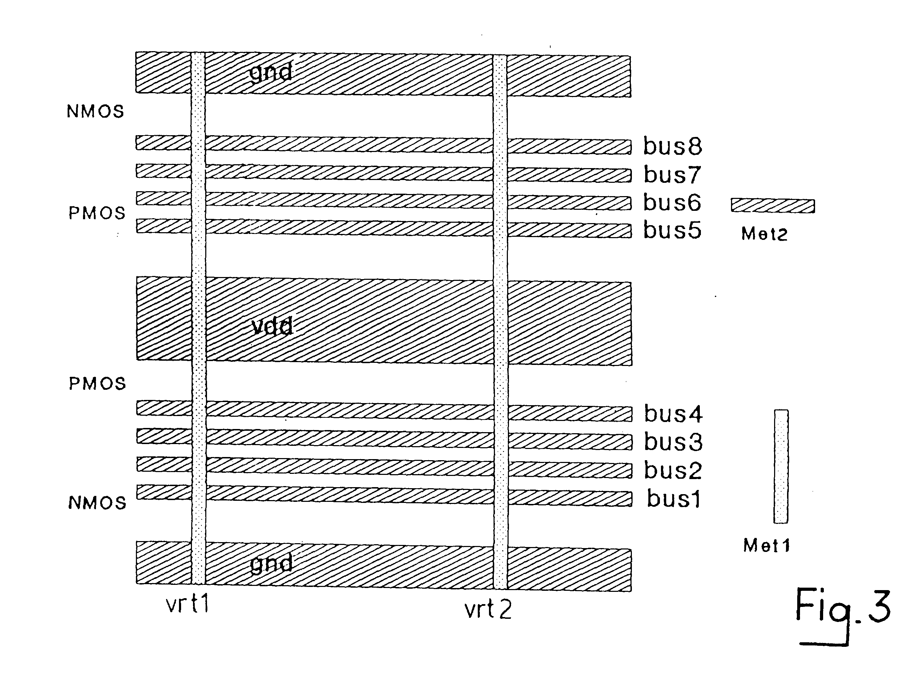

For implementing the supply connection lines and the electric connections between functional cells, according to this invention, electrically conductive paths are used which are laid as shown in the diagram of Figure 3. That diagram covers the connection pattern of a portion of a functional module, it being understood that it would extend horizontally through the entire module and be duplicated vertically to define the patterns for the various functional modules which comprise the modular data processing circuit.

In the invention, the patterns are formed, using a photolithographic process, from two metallic layers built at different levels on the substrate and being isolated from each other and the substrate by thin layers of a dielectric material. Of course, points of contact or interconnection routes may be provided between patterns at different levels and between pattern and substrate, namely between pattern and supply terminals of the module functional elements, to suit specific connection requirements of the individual functional modules.

The supply connection lines consist, for each module, of three horizontal paths which are formed from the farthest metallic layer, referred to as Met2 hereinafter, from the substrate and extend over the areas occupied by the respective modules. Two such paths, denoted by the reference "gnd" and being about 4 µm wide, extend along the horizontal edges of the cells and are intended for connection to the negative pole of a power supply, whereas the third, referenced "vdd" and being twice as wide, extends horizontally across the central regions of the cells, approximately 15 µm away from the lines "gnd" and is intended for connection to the positive pole of a power supply. This layout and sizing of the supply connection lines is of special advantage with CMOS circuits in 0.7 µm technology. In this case, the N-channel MOS transistors would be located in the regions adjacent to the lines "gnd", as indicated in Figure 3 at reference NMOS, and the P-channel MOS transistors would be located in the regions adjacent to the line "vdd" as indicated at reference PMOS. It may be appreciated, however, that the roles of the edge lines and the central line could be exchanged, that is the edge lines could be connected to the positive pole and the central line to the negative pole, in which case the layouts of the transistors NMOS and the transistors PMOS would also be changed around. It may also be appreciated that, with integrated circuits employing components other than CMOS and either more complex or less complex cells than those just described, the number of the supply connection lines to one module could be more than three, and in certain cases less than three, namely two.

In each of the regions included between the central line "vdd" and the lower and upper edge lines "gnd", there have been shown four paths which can also be formed from the metallic layer Met2. Thus, eight paths in all are provided, as indicated at bus1-8 in the drawing. Contrary to the supply connection lines just described, which appear materially in the end structure of all the elementary cells, the paths bus1-8 may be present over limited sections only or be omitted altogether, depending on the interconnection requirements of a particular functional module. In fact, they are arranged for use by the CAD system to the extent that this is strictly necessary. In the example shown in Figure 2, they are used to form the horizontal sections of the interconnection paths between output and input terminals of the individual functional elements.

Figure 3 also shows paths extending along a vertical direction, that is in an orthogonal direction to that of the above-described paths. In this example, they are two in number as indicated at vrt1 and vrt2, formed from the metallic layer next to the substrate and indicated at Met1, and extend over the areas occupied by adjacent functional elements. The same considerations apply to these paths vrt1 and vrt2 as have been made for the paths bus1-8, meaning that they may be present in sections only or be omitted altogether, depending on the specific requirements of the various functional elements. They are arranged for use by the CAD system with two main functions. One function is that of completing the interconnection paths between functional elements by means of vertical sections as shown in Figure 2. Understandably, the horizontal and vertical sections of a particular interconnection path would be connected together by interconnection routes which penetrate the isolating layer that separates the two metalic layers. The other function is that of providing electrically conductive paths for connecting predetermined control terminals of the functional elements to terminals of the modular circuit which are to receive control and command signals, such as clock, set, reset, carry-in, carry-out signals, etc. Notice that such paths on Met1 need not be straight lines within a functional element, but that it is necessary that the junction points between paths for one function belonging to overlaid functional elements in a modular circuit be all located on the same vertical axis; in fact, this enables the automatic vertical connection by a CAD system to be established in quite a simple manner.

In the preferred embodiment of the invention, the modular circuit structure is such that all the input terminals and all the output terminals of the various functional modules are aligned vertically into respective columns.

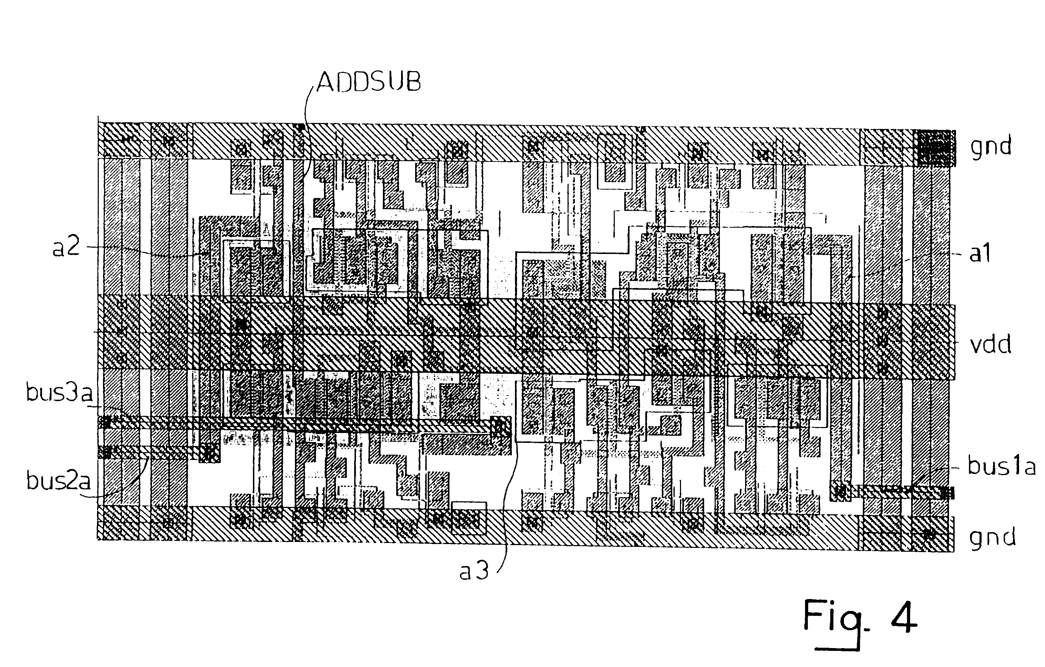

Figure 4 shows by way of example the layout of an elementary cell within a modular circuit structure according to the invention. Depicted therein is an add/subtractor circuit resulting from overlying a set of geometric configurations which correspond to an equal number of manufacturing masks. In the Figure, there are to be seen the three horizontal supply connection lines, gnd and vdd, some horizontal sections formed from the paths bus1-8 and used for interconnection purposes, as indicated at bus1a, bus2a and bus3a, some vertical sections indicated at a1, a2 and a3 which, along with the sections bus1a, bus2a and bus3a, complete three interconnections, and a vertical path, designated ADDSUB, for add and subtract command signals. Notice that the vertical paths extend over free vertical bands of the cell, in this example two edge bands and a central band, which are provided in each cell for passing any vertical connections.

The architecture of the modular circuit is such that, where the horizontal paths provided for interconnection are insufficient, in the example described the eight paths bus1-8, horizontal bands between adjacent functional modules are left available for passing additional horizontal interconnection paths. In such instances, it is the CAD system that will recognize that the interconnection paths bus1-8 are insufficient and provide a horizontal band between modules. This involves increased complexity for the CAD program, but the basic structure of the modular circuit can be left unaltered.

It has been found that in practice the invention allows integrated circuit structures, specifically circuits for parallel processing digital data, to be implemented which are set up as modules over areas which may amount to one third the area required by similar prior art embodiments incorporating standard cells. Concurrently therewith, it has been found that automatic designing is made specially advantageous by that the geometric description of the structure is very simple.

While one embodiment only of the invention has been described and illustrated, it will be appreciated that many changes and modifications may be made thereunto within the scope of the same inventive concept. As an example, instead of using only one of the metallic layers of the pair for making the horizontal paths, and the other layer for vertical path making only, they could be both used to provide horizontal as well as vertical paths where this is made appropriate by considerations of function or geometry. Furthermore, a structure according to the invention may be implemented by forming the conductive paths from three or more metallic layers, rather than two such layers, where the manufacturing process provides for it.

## Claims

1. A modular integrated circuit structure for processing digital data, being formed on a substrate of a semiconductor material and comprising:
a plurality of functional circuit elements (FF1-3,+/-) formed in respective areas of the substrate and provided with respective terminals; and
a plurality of paths of an electrically conductive material extending over the substrate at at least two levels isolated electrically from each other and connecting predetermined terminals of said functional elements together and/or to circuit terminals for external connection, thereby forming functional modules (M0, M1) which have supply (gnd, vdd), input/output (A,B,C), and control (CLK, ADDSUB) terminals, make up in combination said integrated circuit for processing digital data, and are effective each to perform predetermined parallel processing of two or more bits of the same order (A0, B0; A1, B1) belonging to digital data being applied to respective input terminals, so as to issue the processing result on respective output terminals;
the functional elements (FF1-3,+/-) forming one module being laid adjacent to each other along a first direction and having the same spread along a second direction orthogonal to the first;
the modules being laid adjacent to each other along the second direction; and
the electrically conductive material paths comprising:
module supply paths (gnd, vdd) extending in the first direction over the areas occupied by respective modules and connecting together predetermined supply terminals of the functional elements in each module;
control paths (CLK, ADDSUB) connecting together predetermined control terminals of different modules and extending over the areas occupied by respective modules, each passing over points lying in different modules on a common axis along the second direction; and
interconnection paths connecting together predetermined terminals of functional elements in each module, extending over the areas occupied by respective functional elements and being formed at least in part by sections which extend in the first direction along one of a plurality of parallel lines (bus1-8) included between the supply connection paths (gnd, vdd) at spacings therefrom which are the same for all the modules.

2. A structure according to Claim 1, wherein the input terminals (A0, B0; A1, B1) and output terminals (C0, C1) of the functional modules are aligned into an input column and an output column, respectively, extending in the second direction.

3. A structure according to either Claim 1 or 2, wherein the module supply paths (gnd, vdd) lie at a first of the said isolated levels;
the control paths (CLK, ADDSUB) lie at a second of the said isolated levels;
said sections of the interconnection paths lie at the first of the said levels, the interconnection paths being formed at least in part by further sections (a1, a2 and a3) which extend in the second direction at the second of the said levels, those sections of interconnection paths which include both said sections and said further sections being connected together by electrically conductive routes extending between the first and second levels.

4. A structure according to Claim 3, wherein there are three supply connection paths for each module, of which two (gnd) extend along the edges and one (vdd) across a central region of a respective module.

5. A structure according to any of the preceding claims, wherein at least one of the interconnection paths extends at least partway along the first direction over a substrate area provided between adjacent functional modules.

6. A structure according to any of Claims 3 to 5, wherein the further sections (a1, a2 and a3) of the interconnection paths extend, for each functional element, on free regions in the second direction.

## Patentansprüche

1. Eine modulare integrierte Schaltungsstruktur zur verarbeitung von digitalen Daten, die auf einem Substrat aus einem Halbleitermaterial gebildet ist, mit folgenden Merkmalen:
einer Mehrzahl von funktionellen Schaltungselementen (FF1-3, +/-), die in jeweiligen Flächen des Substrats gebildet und mit jeweiligen Anschlüssen versehen sind; und
einer Mehrzahl von Wegen aus einem elektrisch leitfähigen Material, die sich in zumindest zwei Ebenen, die voneinander elektrisch isoliert sind, über das Substrat erstrecken und vorbestimmte Anschlüsse der funktionellen Elemente miteinander und/oder mit Schaltungsanschlüssen für eine externe Verbindung verbinden, wodurch funktionelle Module (M0, M1) gebildet werden, die Versorgungs- (gnd, vdd), Eingangs/Ausgangs- (A, B, C) und Steuer- (CLK, ADDSUB) -Anschlüsse aufweisen, welche in Kombination die integrierte Schaltung für die Verarbeitung digitaler Daten bilden und jeweils wirksam sind, um eine parallele Verarbeitung von zwei oder mehr Bits der gleichen Ordnung (A0, B0; A1, B1), die zu digitalen Daten gehören, die jeweiligen Eingangsanschlüssen zugeführt werden, durchzuführen, um das Verarbeitungsergebnis auf jeweiligen Ausgangsanschlüssen auszugeben;
wobei die funktionellen Elemente (FF1-3, +/-), die ein Modul bilden, benachbart zueinander entlang einer ersten Richtung angeordnet sind und die gleiche Ausbreitung entlang einer zweiten Richtung, die orthogonal zu der ersten ist, aufweisen;
wobei die Module benachbart zueinander entlang der zweiten Richtung angeordnet sind; und
wobei die Wege aus einem elektrisch leitfähigen Material folgende Merkmale aufweisen:
Modulversorgungswege (gnd, vdd), die sich in der ersten Richtung über die Flächen, die durch jeweilige Module besetzt sind, erstrecken und vorbestimmte Versorgungsanschlüsse der funktionellen Elemente in jedem Modul miteinander verbinden;
Steuerwege (CLK, ADDSUB), die vorbestimmte Steueranschlüsse der verschiedenen Module miteinander verbinden und die sich über die Flächen, die durch jeweilige Module besetzt sind, erstrecken, wobei jeder über Punkte verläuft, die in unterschiedlichen Modulen auf einer gemeinsamen Achse entlang der zweiten Richtung liegen; und
Verbindungswege, die vorbestimmte Anschlüsse der funktionellen Elemente in jedem Modul miteinander verbinden, welche sich über die Flächen, die durch jeweilige funktionelle Elemente besetzt sind, erstrecken und zumindest teilweise durch Abschnitte gebildet sind, die sich in der ersten Richtung entlang einer einer Mehrzahl von parallelen Linien (Bus1-8), die zwischen den Versorgungsverbindungswegen (gnd, vdd) enthalten sind, mit Abständen von denselben, die für alle Module die gleichen sind, erstrecken.

2. Eine Struktur gemäß Anspruch 1, bei der die Eingangsanschlüsse (A0, B0; A1, B1) und Ausgangsanschlüsse (C0, C1) der funktionellen Module in einer Eingangsspalte bzw. einer Ausgangsspalte, die sich in der zweiten Richtung erstrecken, ausgerichtet sind.

3. Eine Struktur gemäß Anspruch 1 oder 2, bei der
die Modulversorgungswege (gnd, vdd) in einer ersten der isolierten Ebenen liegen;
die Steuerwege (CLK, ADDSUB) in einer zweiten der isolierten Ebenen liegen;
die Abschnitte der Verbindungswege in der ersten der Ebenen liegen, wobei die Verbindungswege zumindest teilweise durch weitere Abschnitte (a1, a2 und a3), die sich in der zweiten der Ebenen in der zweiten Richtung erstrecken, gebildet sind, wobei diese Abschnitte der Verbindungswege, die sowohl die Abschnitte als auch die weiteren Abschnitte einschließen, durch elektrisch leitfähige Leitwege, die sich zwischen der ersten und der zweiten Ebene erstrecken, miteinander verbunden sind.

4. Eine Struktur gemäß Anspruch 3, bei der drei Versorgungsverbindungswege für jedes Modul vorgesehen sind, wobei sich zwei (gnd) entlang der Ränder erstrecken und einer (vdd) sich über eine zentrale Region eines jeweiligen Moduls erstreckt.

5. Eine Struktur gemäß einem beliebigen der vorhergehenden Ansprüche, bei der sich zumindest einer der Verbindungswege teilweise entlang der ersten Richtung über eine Substratfläche, die zwischen benachbarten funktionellen Modulen vorgesehen ist, erstreckt.

6. Eine Struktur gemäß einem beliebigen der Ansprüche 3 bis 5, bei der sich die weiteren Abschnitte (a1, a2 und a3) der Verbindungswege für jedes funktionelle Element auf freien Regionen in der zweiten Richtung erstrecken.

## Revendications

1. Structure de circuit intégré modulaire pour traitement de données numériques, étant formée sur un substrat fait de matière semiconductrice et comprenant :
plusieurs éléments de circuit fonctionnel (FF1-3, +/-) formés dans des zones respectives sur le substrat et pourvus de bornes respectives ; et
plusieurs trajets faits d'une matière conductrice de l'électricité s'étendant sur le substrat à au moins deux niveaux isolés électriquement l'un de l'autre et connectant des bornes prédéterminées desdits éléments fonctionnels les unes avec les autres et/ou avec des bornes de circuit pour une connexion externe, en formant ainsi des modules fonctionnels (M0, M1) qui comportent des bornes d'alimentation (gnd, vdd), des bornes d'entrée/sortie (A, B, C), et des bornes de commande (CLK, ADDSUB), constituant en combinaison ledit circuit intégré pour traitement de données numériques, et servant chacun à effectuer un traitement parallèle prédéterminé de deux bits, ou plus, du même ordre (A0, B0 ; A1, B1) appartenant aux données numériques appliquées aux bornes d'entrée respectives, de façon à sortir le résultat de traitement sur des bornes de sortie respectives ;
les éléments fonctionnels (FF1-3, +/-), formant un module, étant placés adjacents les uns aux autres le long d'une première direction et ayant la même étendue le long d'une seconde direction orthogonale à la première ;
les modules étant adjacents les uns aux autres le long de la seconde direction ; et
les trajets faits de matière conductrice de l'électricité comprenant :
des trajets d'alimentation (gnd, vdd) de module s'étendant dans la première direction sur les zones occupées par des modules respectifs et connectant les unes avec les autres des bornes d'alimentation prédéterminées des éléments fonctionnels dans chaque module ;
des trajets de commande (CLK, ADDSUB) connectant les unes avec les autres des bornes de commande prédéterminées de modules différents et s'étendant sur les zones occupées par des modules respectifs, chacun passant par des points se trouvant dans des modules différents sur un axe commun le long de la seconde direction ; et
des trajets d'interconnexion connectant les unes avec les autres des bornes prédéterminées d'éléments fonctionnels dans chaque module, s'étendant sur les zones occupées par des éléments fonctionnels respectifs et étant formés au moins en partie par des sections qui s'étendent dans la première direction le long d'une pluralité de lignes parallèles (bus1-8) comprises entre les trajets de connexion d'alimentation (gnd-vdd) à des espacements de ceux-ci qui sont les mêmes pour tous les modules.

2. Structure selon la revendication 1, dans laquelle les bornes d'entrée (A0, B0 ; A1, B1) et les bornes de sortie (C0, C1) des modules fonctionnels sont alignées, respectivement, en une colonne d'entrée et en une colonne de sortie s'étendant dans la seconde direction.

3. Structure selon l'une quelconque des revendications 1 ou 2, dans laquelle les trajets d'alimentation (gnd, vdd) de module se trouvent à un premier desdits niveaux isolés ;
les trajets de commande (CLK, ADDSUB) se trouvent à un second desdits niveaux isolés ;
lesdites sections des trajets d'interconnexion se trouvent au premier desdits niveaux, les trajets d'interconnexion étant formés au moins en partie par des sections (a1, a2 et a3) supplémentaires qui s'étendent dans la seconde direction au niveau du second desdits niveaux, les sections des trajets d'interconnexion qui comprennent à la fois lesdites sections et lesdites sections supplémentaires étant connectées les unes avec les autres par des tracés conducteurs de l'électricité s'étendant entre les premier et second niveaux.

4. Structure selon la revendication 3, dans laquelle il existe trois trajets de connexion d'alimentation pour chaque module, dont deux (gnd) s'étendent le long des bords et un (vdd) traverse une région centrale d'un module respectif.

5. Structure selon l'une quelconque des revendications précédentes, dans laquelle au moins l'un des trajets d'interconnexion s'étend au moins en partie le long de la première direction sur une zone de substrat disposée entre des modules fonctionnels adjacents.

6. Structure selon l'une quelconque des revendications 3 à 5, dans laquelle les sections (a1, a2 et a3) supplémentaires des trajets d'interconnexion s'étendent, pour chaque élément fonctionnel, sur des régions libres, dans la seconde direction.
